# EUROPEAN PATENT APPLICATION

(11) **EP 1 075 166 A2**
(43) Date of publication of application: **07.02.2001**
(21) Application number: 00116885.5
(22) Date of filing: 04.08.2000
(51) Int. Cl.: H05B 33/06, H05B 33/26

(54) **EL display device**

(30) Priority: 06.08.1999 JP 22366799
(71) Applicant: Harness System Technologies Research, Ltd., Nagoya-shi, Aichi (JP); Sumitomo Wiring Systems, Ltd., Yokkaichi-shi Mie-ken (JP); SUMITOMO ELECTRIC INDUSTRIES, LTD., Osaka-shi, Osaka (JP)
(72) Inventor: Tomida, Takayuki, c/o Harness System Technologies, Nagoya-shi, Aichi (JP)
(74) Representative: Kuhnen & Wacker

(57) **Abstract**

The whole of an anode line WYA1 elongating from a segment A1 is covered by an insulating layer 3. The portion of the insulating layer 3 where the anode line is to be electrically connected to an anode connecting line WXA is removed away to be formed as an opening CH. The anode connecting line WXA crosses over an anode line WYB1 elongating from a segment B1, and an anode line WYC1 elongating from a segment C1, to reach above an anode line WYA2 for a segment A2, and is electrically connected to the anode line WYA2 through the opening CH.

## Description

### BACKGROUND OF THE INVENTION

The present invention relates to an EL (electroluminescent) display device.

As the recent development of technology, meters such as a speed meter of an automobile are frequently configured by EL display in place of conventional analog needle display. In the case of a speed meter or the like, a large number of display segments are required. A display device having such a large number of segments is driven by either of static driving in which driving elements are respectively connected to the segments and individually controlled, and dynamic driving in which plural segments are connected in parallel to one driving element and driven in a time divisional manner.

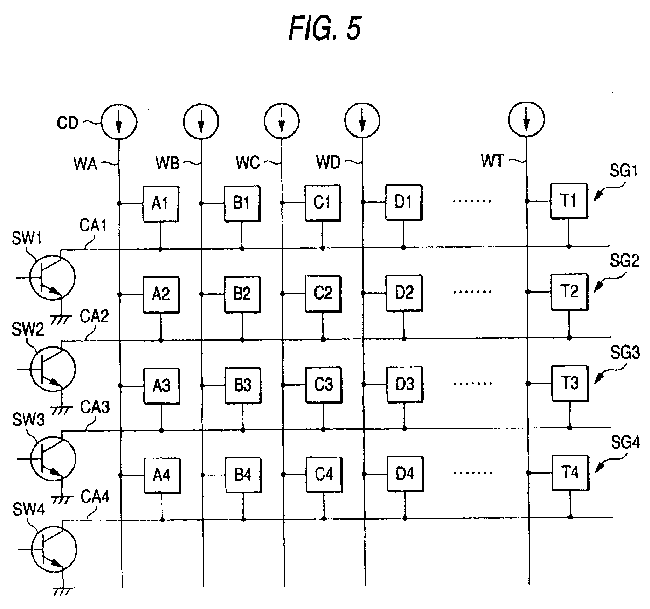

Fig. 5 is a diagram of a matrix circuit of an EL display device in the case where dynamic driving is performed.

Referring to Fig. 5, a segment arrangement SG1 is configured by twenty segments A1 to T1 in which the cathodes are commonly connected to a cathode line CA1. The anodes are connected to anode lines WA to WT, respectively.

Similarly, a segment arrangement SG2 is configured by twenty segments A2 to T2 in which the cathodes are commonly connected to a cathode line CA2 and the anodes are connected to the anode lines WA to WT, respectively. A segment arrangement SG3 is configured by twenty segments A3 to T3 in which the cathodes are commonly connected to a cathode line CA3 and the anodes are connected to the anode lines WA to WT, respectively, and a segment arrangement SG4 is configured by twenty segments A4 to T4 in which the cathodes are commonly connected to a cathode line CA4 and the anodes are connected to the anode lines WA to WT, respectively.

The cathode lines CA1 to CA4 are connected to main terminals on one side of transistors SW1 to SW4, respectively. The other main terminals of the transistors SW1 to SW4 are grounded. The cathode lines CA1 to CA4 are controlled to be grounded or ungrounded, by ON/OFF operations of the transistors SW1 to SW4. Current source drivers CD which can be ON/OFF-controlled are connected to the anode lines WA to WT, respectively.

The thus configured matrix circuit operates in the following manner. When the current source driver CD connected to the anode line WA is turned ON under the state where the transistor SW1 is turned ON, for example, a voltage is applied to the segment A1 and the segment emits light. When the current source driver CD connected to the anode line WB is then turned ON, the segment B1 emits light. In this way, the current source drivers CD are ON/OFF-controlled in accordance with predetermined column data, so that ON/OFF operations of the segments on the segment arrangement SG1 can be arbitrarily controlled.

After the transistor SW1 is turned ON for a predetermined period, the transistor SW1 is turned OFF, the transistor SW2 is set to the ON state, and the current source drivers CD are then ON/OFF-controlled in accordance with predetermined column data, so that ON/OFF operations of the segments on the segment arrangement SG2 are controlled. When the operations of the segment arrangements are controlled in a time divisional manner as described above and the repetition rate of the time divisional operation is made higher than the time resolution of the human eyes, the user recognizes as if predetermined segments always emit light.

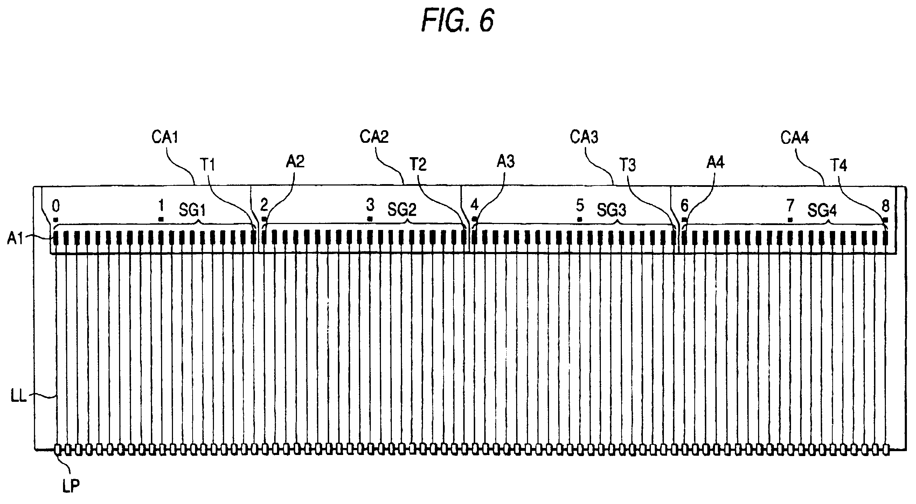

Fig. 6 shows the configuration of an EL display device which performs bar segment display corresponding to the matrix circuit described above. Referring to Fig. 6, a segment arrangement SG1 configured by twenty segments A1 to T1, a segment arrangement SG2 configured by twenty segments A2 to T2, a segment arrangement SG3 configured by twenty segments A3 to T3, and a segment arrangement SG4 configured by twenty segments A4 to T4 are arranged in one row.

The cathode lines CA1 to CA4 of the segment arrangements SG1 to SG4 are independently formed into a flat plate-like shape and arranged in the arrangement direction of the segment arrangements SG1 to SG4.

Usually, cathodes and anodes which are commonly connected among segments are connected to the corresponding ones in a display device, so that the number of lead pins which are drawn out to the outside of the display device is reduced as far as possible.

In the EL display device shown in Fig. 6, however, common anodes in the segment arrangements SG1 to SG4, i.e., anodes constituting one column in the matrix shown in Fig. 5 cannot be connected to one another inside the device. When the anode of the segment A1 in Fig. 6 is to be connected to that of the segment A2, for example, the wiring for the connection must cross anode lines elongating from the anodes of segments B1 to T1. However, a transparent electrode layer serving as the anodes of the EL elements and also as the anode lines is configured as a single layer, and hence the connection wiring cannot cross the other anode lines which must be electrically separated from the wiring.

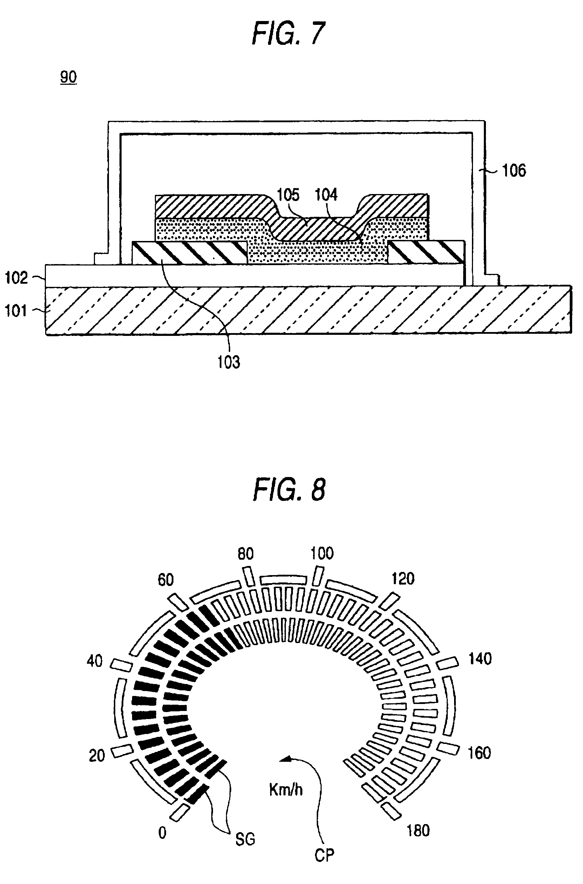

Fig. 7 shows the section configuration of an organic EL element 90 which is usually used. As shown in Fig. 7, the EL element 90 comprises: a transparent substrate 101 configured by a thin glass substrate, a transparent resin substrate, or the like; a transparent electrode layer 102 which is formed on the transparent substrate 101 and made of a transparent material such as an ITO (indium-tin-oxide) film; an insulating layer 103 which is formed on the transparent electrode layer 102 so as to have a predetermined opening; an organic light emitting layer 104 configured by a single layer or plural layers and made of a predetermined organic material which is formed so as to extend over from the insulating layer 103 to the transparent electrode layer 102 exposed through the bottom face of the opening of the insulating layer 103; a metal electrode layer 105 which is vapor-deposited onto the organic light emitting layer 104; and a sealing case member 106 made of glass or a metal such as aluminum.

In order to connect anodes of such EL elements to each other, the transparent electrode layers 102 must be connected to each other. As described above, each of the transparent electrode layers 102 is configured as a single layer. When the connection wiring crosses the other anode lines which must be electrically separated from the wiring, therefore, a short circuit occurs.

In the EL display device shown in Fig. 6, consequently, connection between segments is not performed in the display device, but conducted in the following manner. Anode lines LL are drawn out from the segments and then connected to lead pins LP, respectively. Predetermined ones of the lead pins LP are connected to one another outside the display device.

Therefore, the arrangement pitch of the segments is restricted by the arrangement pitch (about 1.5 to 2 mm) of the lead pins LP. Consequently, the arrangement pitch of the segments cannot be reduced, and the display device is enlarged in size. Even when the arrangement pitch of the segments is reduced, the arrangement pitch of the lead pins LP cannot be reduced, and hence a large transparent substrate is required in order to arrange the lead pins LP. As a result, there arises a problem in that the size of the display device is increased.

The above is similarly applicable also to EL display in the form of analog needle display such as shown in Fig. 8. In the EL display in the form of analog needle display such as shown in Fig. 8, when an anode line is drawn out from each of segments, the lines are concentrated into the center area CP of segments SG which are radiately arranged. Therefore, a large area must be ensured as a region for the lines, and hence it is required to prepare a transparent substrate the area of which is large as compared with that of the segment portion, with the result that the size of the display device is increased.

When a flexible printed circuit board (FPC) is used in place of lead pins, the arrangement pitch of the segments can be reduced to about 0.5 mm. However, an FPC is expensive, and hence causes a problem in that the production cost is increased.

### SUMMARY OF THE INVENTION

The invention has been conducted in order to solve the problems. It is an object of the invention to provide an EL display device in which connection between anodes is enabled inside the device, the number of lead pins is made smaller, and the arrangement pitch of segments is reduced, thereby miniaturizing the device.

In a first aspect of the invention, the EL display device comprises: a transparent substrate; a first electrode pattern layer which has plural first electrode portions patterned on the transparent substrate and corresponding to segment shapes, and plural first electrode lead portions respectively elongating from the first electrode portions; an insulating layer which is patterned so as to allow the plural first electrode portions to be exposed, and cover the plural first electrode lead portions; plural light emitting layers which are respectively patterned on the plural first electrode portions; plural second electrode pattern layers which are patterned to group the plural light emitting layers into plural groups in each of which light emitting layers are commonly electrically connected to one another, and to extend over plural light emitting layers in a group; and plural first electrode wiring layers which are disposed on the insulating layer to cross the first electrode lead portions, and through which corresponding first electrode lead portions among the second electrode pattern layers are electrically connected to one another via openings that are disposed to pass through the insulating layer.

In a second aspect of the invention, the first electrode wiring layers are metal layers.

In a third aspect of the invention, the first electrode wiring layers are made of a same material as the second electrode pattern layers.

### BRIEF DESCRIPTION OF THE DRAWINGS

Fig. 1 is a diagram of a matrix circuit of an EL display device which is an embodiment of the invention.
Fig. 2 is a view schematically showing the configuration of the EL display device of the embodiment of the invention.
Fig. 3 is a plan view showing the configuration of a part of the EL display device of the embodiment of the invention.
Fig. 4 is a section view showing the configuration of the EL display device of the embodiment of the invention.
Fig. 5 is a diagram showing a matrix circuit of an EL display device in which dynamic driving is performed.
Fig. 6 is a view schematically showing the configuration of the EL display device in which dynamic driving is performed.
Fig. 7 is a section view showing the configuration of a conventional EL element.
Fig. 8 is a view showing an EL display device in the form of analog needle display.

### DETAILED DESCRIPTION OF THE PREFERRED EMBODIMENTS

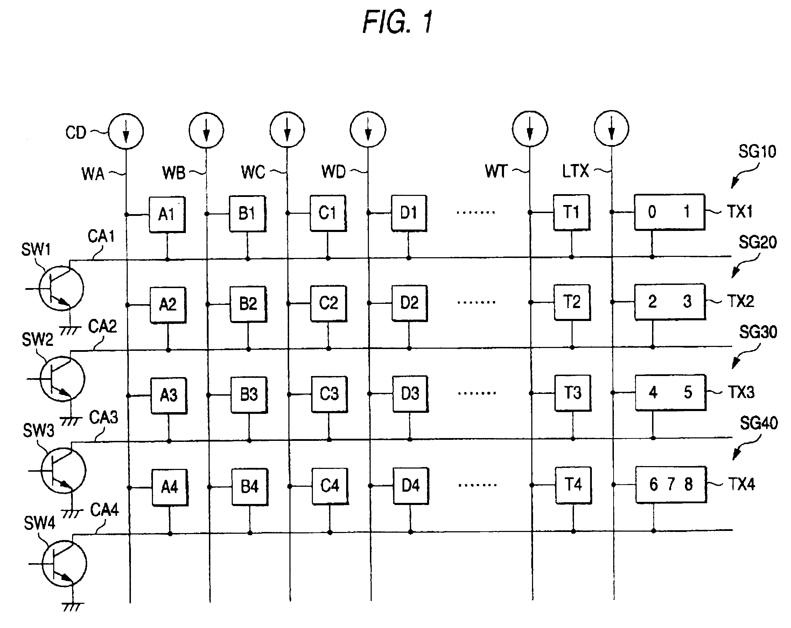

Fig. 1 is a diagram of a matrix circuit of an EL display device which is an embodiment of the invention.

Referring to Fig. 1, a segment arrangement SG10 is configured by twenty-one segments, or segments A1 to T1 in which the cathodes are commonly connected to a cathode line CA1, and a segment TX1. The anodes are connected to anode lines WA to WT, and LTX, respectively.

Similarly, a segment arrangement SG20 is configured by twenty-one segments, or segments A2 to T2 in which the cathodes are commonly connected to a cathode line CA2 and the anodes are connected to the anode lines WA to WT, and LTX, respectively. A segment arrangement SG30 is configured by twenty-one segments, or segments A3 to T3 in which the cathodes are commonly connected to a cathode line CA3 and the anodes are connected to the anode lines WA to WT, and LTX, respectively, and a segment arrangement SG40 is configured by twenty-one segments, or segments A4 to T4 in which the cathodes are commonly connected to a cathode line CA3 and the anodes are connected to the anode lines WA to WT, and LTX, respectively.

The cathode lines CA1 to CA4 are connected to main terminals on one side of transistors SW1 to SW4, respectively. The other main terminals of the transistors SW1 to SW4 are grounded. The cathode lines CA1 to CA4 are controlled to be grounded or ungrounded, by ON/OFF operations of the transistors SW1 to SW4. Current source drivers CD which can be ON/OFF-controlled are connected to the anode lines WA to WT, and LTX, respectively.

The segments TX1 to TX4 are formed into shapes of characters. The segment TX1 has shapes of numerals 0 and 1, the segment TX2 has shapes of numerals 2 and 3, the segment TX3 has shapes of numerals 4 and 5, and the segment TX4 has shapes of numerals 6, 7, and 8.

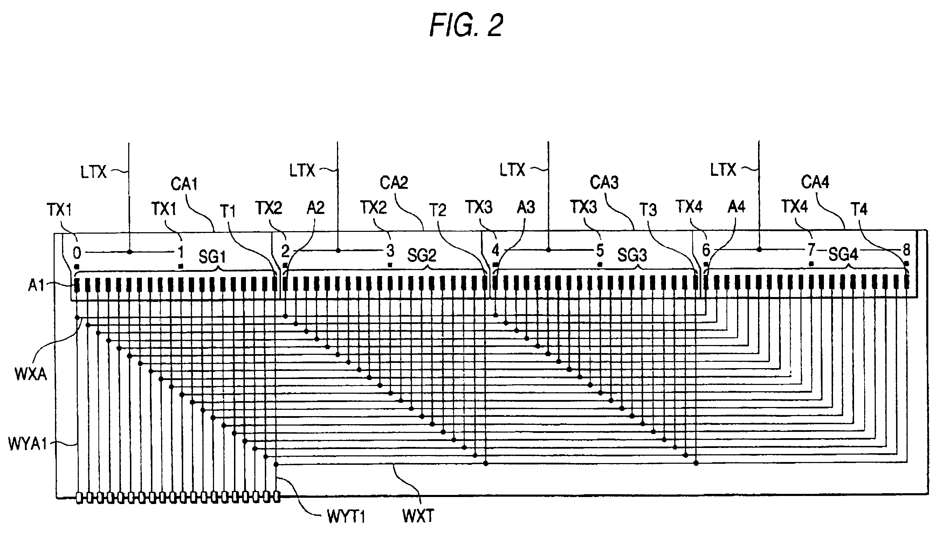

Fig. 2 shows the configuration of an EL display device which performs bar segment display corresponding to the matrix circuit described above. Referring to Fig. 2, arranged are a segment arrangement SG1 configured by the twenty segments A1 to T1 which are arranged in one row, a segment arrangement SG2 configured by the twenty segments A2 to T2 which are arranged in one row, a segment arrangement SG3 configured by the twenty segments A3 to T3 which are arranged in one row, and a segment arrangement SG4 configured by the twenty segments A4 to T4 which are arranged in one row.

The segments TX1, TX2, TX3, and TX4 are arranged in parallel to the segment arrangements SG1, SG2, SG3, and SG4. Specifically, numeral 0 is placed so as to be juxtaposed to the segment A1, and the subsequent numerals are arranged at intervals of ten segments. The numerals are used as an example. The contents to be displayed may be adequately changed in accordance with the purpose of the EL display device.

The cathode lines CA1 to CA4 (second electrode pattern layers) are independently formed into a flat plate-like shape and disposed so as to respectively correspond to the segment arrangements SG1 to SG4.

In the EL display device shown in Fig. 2, corresponding anodes of the segment arrangements SG1 to SG4 are commonly connected to one another inside the device. In Fig. 2, for example, the anodes (first electrode portions) of the segments A1, A2, A3, and A4 are commonly connected to one another by an anode connecting line WXA (first electrode wiring layer), and the anode connecting line WXA is connected to an anode line WYA1 (first electrode lead portion) elongating from the segment A1 to be drawn out to the outside of the display device. The anode connecting line WXA and the anode line WYA1 correspond to the anode line WA shown in Fig. 1.

The above is similarly applicable also to the other common segments. As a result, the anode lines respectively corresponding to the anode lines WA to WT shown in Fig. 1 are sequentially arranged with starting from the anode connecting line WXA and the anode line WYA1 connecting the anodes of the segments A1, A2, A3, and A4, to an anode connecting line WXT and an anode line WYT1 connecting the anodes of the segments T1, T2, T3, and T4. The anode connecting lines cross the anode lines elongating from the anodes of the segments.

According to this configuration, including the anode line TLX connected to the anodes of the segments TX1 to TX4 (in the figure, four lines are shown for the sake of convenience, but only one line is actually used), the number of the anode lines which are drawn out to the outside of the display device is twenty-one. Even when lead pins are used for drawing out the anodes, the arrangement pitch of the segments is not restricted by the arrangement pitch of the lead pins. Furthermore, even when the arrangement pitch of the segments is reduced to the lower limit, a region for arranging lead pins can be ensured on a transparent substrate because it is not required to dispose anode lines corresponding to all of the segments. Therefore, the transparent substrate is not required to be enlarged to comply with the arrangement region of the lead pins.

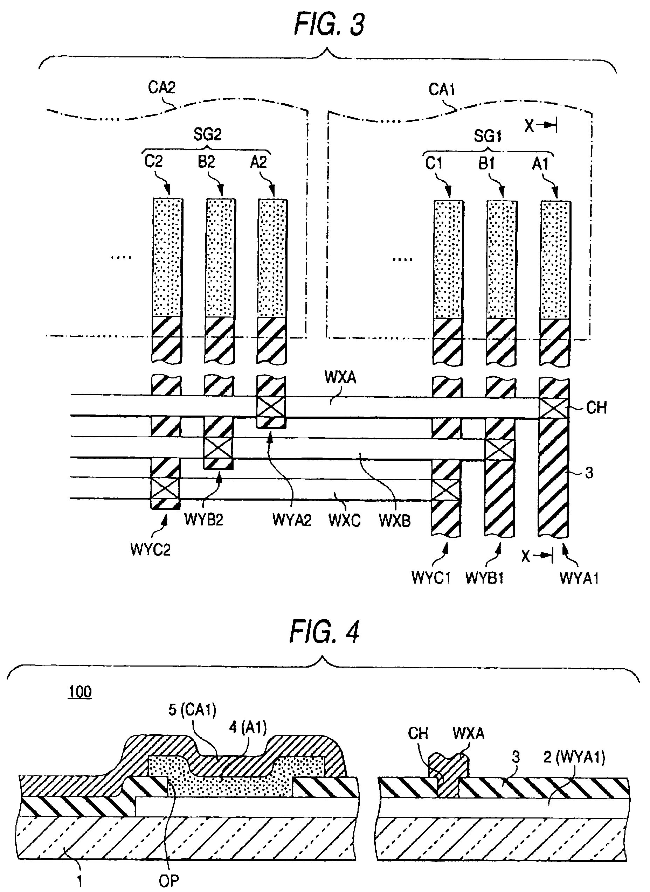

The above-described common connection of the anodes inside the display device is enabled by the use of the EL elements having the structure in which the anode lines can cross one another. Hereinafter, the configuration of the EL element will be described with reference to Figs. 3 and 4.

Fig. 3 is a partial plan view of the EL display device shown in Fig. 2, as seen from the rear side (the side of the cathode lines) of the sheet.

Fig. 3 shows a part of the segment arrangements SG1 and SG2. Referring to Fig. 3, the whole of the anode line WYA1 elongating from the segment A1 is covered by an insulating layer 3. The portion of the insulating layer 3 where the anode line is to be electrically connected to the anode connecting line WXA is removed away to be formed as an opening CH. The anode connecting line WXA crosses over the anode line WYB1 elongating from the segment B1, and the anode line WYC1 elongating from the segment C1, to reach above the anode line WYA2 for the segment A2, and is electrically connected to the anode line WYA2 through the opening CH.

This structure is similarly applied also to the anode line WYB1 elongating from the segment B1, the anode line WYC1 elongating from the segment C1, and the anode lines elongating from the segments D1 to T1 which are not shown.

The above-described crossing of the anode lines is enabled by the configuration in which the anode lines elongating from the segments are covered by the insulating layer 3 so as to maintain insulation among the anode lines which are to be electrically separated from the lines.

Fig. 4 shows the section configuration taken along the line X-X in Fig. 3, i.e., the section configuration of an EL element 100. Referring to Fig. 4, the EL element 100 comprises: a transparent substrate 1 configured by a thin glass substrate, a transparent resin substrate, or the like; a transparent electrode layer 2 which is formed on the transparent substrate 1 and made of a transparent material such as an ITO (indium-tin-oxide) film; the insulating layer 3 which is formed on a substantially entire area of the transparent electrode layer 2 (first electrode pattern layer) so as to have an opening OP and the opening CH; an organic light emitting layer 4 configured by a single layer or plural layers and made of a predetermined organic material which is formed so as to extend over from the insulating layer 3 to the transparent electrode layer 2 exposed through the bottom face of the opening of the insulating layer 3; and a metal electrode layer 5 (second electrode pattern layer) which is formed by, for example, vapor-depositing aluminum or the like onto the organic light emitting layer 4. The metal electrode layer 5 corresponds to the cathode line CA1, and the organic light emitting layer 4 corresponds to the segment A1. In the transparent electrode layer 2, the portion opposed to the organic light emitting layer 4 is the so-called anode (first electrode portion) of the segment, and the other portion corresponds to the anode line WYA1 (first electrode lead portion).

The anode connecting line WXA (first electrode wiring layer) is connected to the anode line WYA1 of the transparent electrode layer 2 through the opening CH. The anode connecting line WXA is formed in the same step as the metal electrode layer 5.

Since the substantially entire area of the transparent electrode layer 2 is covered by the insulating layer 3, the anode connecting lines can cross over the transparent electrode layer 2 via the insulating layer 3, whereby degree of freedom in wiring pattern of the anode lines in the display device can be enhanced.

Since the anode connecting lines are configured by metal lines, the electrical resistance is lower than that of lines configured by an ITO film, so that the wiring resistance from a lead pin to a segment is lowered. As a result, it is possible to reduce the voltage drop and heat generation due to a wiring which is not related to light emission.

When the electrical resistance of the anode connecting lines is set to be equal to that of lines configured by an ITO film, the anode connecting lines can be thinner than lines configured by an ITO film, and hence the area of the non-light emitting portion in the display device can be reduced.

In the above, the organic EL display device configured by organic EL elements having an organic light emitting layer has been described as an example. It is a matter of course that the application of the invention is not restricted to an organic EL display device and the invention may be applied to an EL display device configured by EL elements having an inorganic light emitting layer such as ZnS.

In the above, the embodiment in which the anode connecting lines are formed in the same step as the cathodes has been described. It is a matter of course that, when increase of the number of steps is not problematic, the cathodes and the anode connecting lines are formed in different steps and by different materials.

In the above, the display device in which segments are linearly arranged has been described. It is a matter of course that the invention can be similarly applied to a display device in which segments are radiately arranged so as to constitute analog needle display.

In the EL display device of the first aspect of the invention, the insulating layer is patterned so as to allow the plural first electrode portions to be exposed, and cover the plural first electrode lead portions, and corresponding plural first electrode lead portions among the plural second electrode pattern layers are connected to one another by the plural first electrode wiring layers via the openings that are disposed to pass through the insulating layer. Even when the first electrode wiring layers cross over the first electrode lead portions which are to be electrically separated therefrom, therefore, insulation of the first electrode lead portions which are to be electrically separated can be maintained by the insulating layer. Consequently, degree of freedom in wiring pattern of the first electrode lead portions and the first electrode wiring layers in the EL display device is enhanced, so that the number of the first electrode lead portions which are drawn out to the outside of the display device can be reduced.

According to the EL display device of the second aspect of the invention, since the first electrode wiring layers are metal layers, the electrical resistance is lower, so that the wiring resistance from an input portion of the first electrode lead portions to the segments is lowered. As a result, it is possible to reduce the voltage drop and heat generation due to a wiring which is not related to light emission.

According to the EL display device of the third aspect of the invention, since the first electrode wiring layers are made of the same material as the second electrode pattern layers, the number of production steps can be reduced and the production cost can be prevented from being increased.

## Claims

1. An EL display device comprising:
a transparent substrate;
a first electrode pattern layer which has plural first electrode portions patterned on said transparent substrate and corresponding to segment shapes, and plural first electrode lead portions respectively elongating from said first electrode portions;
an insulating layer which is patterned so as to allow said plural first electrode portions to be exposed, and cover said plural first electrode lead portions;
plural light emitting layers which are respectively patterned on said plural first electrode portions;
plural second electrode pattern layers which are patterned to group said plural light emitting layers into plural groups in each of which light emitting layers are commonly electrically connected to one another, and to extend over plural light emitting layers in a group; and
plural first electrode wiring layers which are disposed on said insulating layer to cross said first electrode lead portions, and through which corresponding first electrode lead portions among said second electrode pattern layers are electrically connected to one another via openings that are disposed to pass through said insulating layer.

2. The EL display device according to claim 1, wherein said first electrode wiring layers are metal layers.

3. The EL display device according to claim 1, wherein
said first electrode wiring layers are made of a same material as said second electrode pattern layers.
